# EUROPEAN PATENT APPLICATION

(11) **EP 1 227 418 A1**
(43) Date of publication of application: **31.07.2002**
(21) Application number: 00311548.2
(22) Date of filing: 21.12.2000
(51) Int. Cl.: G06F 17/50

(54) **System for generating buildings according to requirements**

(71) Applicant: Rockwool International A/S, 2640 Hedehusene (DK)
(72) Inventor: The designation of the inventor has not yet been filed
(74) Representative: Haley, Stephen

(57) **Abstract**

A system for assisting in the determination of building specification compliance with a predetermined regulation. The system comprises construction data receiving means for receiving, from a user, construction data relating to a component in a building design, the construction data receiving means including reference data storage means from which a user can select reference construction materials and construction configurations to input as construction data for a component calculating means calculates on the basis of the input construction data, compliance data to be output to a user. A display displays the compliance data along side the component for which it has been calculated.

## Description

This invention relates to a system for assisting designers in relation to the determination of the compliance or otherwise of a building design with respect to a national or international building standard.

It will be appreciated that building design is extremely complex and requires the consideration of many factors during that design. For example, when designing a building there are cost and aesthetic considerations requirements, as well as other considerations such as strength, durability, and ease of construction. For many years there has, as an additional consideration, been the need to take into consideration the building regulations applying in the location where the building is to be constructed. These regulations can relate to quality of materials and strength of construction, as well as expected life time of construction, and in recent years have been extended to take into account other considerations, such as compliance with environmental standards, the ability to provide adequate heat and ventilation,. etc. Such regulations are becoming increasingly complex and demanding. This, in conjunction with increasing demands from the end users of buildings, such as satisfactory climate means that it is often that extremely difficult and time consuming for a building designer to determine whether or not a proposed building design meets the necessary regulations whilst satisfying other constraints, and if it does not, how best to rectify the design at an early stage to ensure that such regulations are met.

In the past there have been various attempts to assist designers in the determination of whether or not a design meets the appropriate regulation in the form of computer-based programs and look-up tables. For example, in relation to the need for a building to meet certain thermal regulation requirements, simple programs are available in which it is possible to input key characteristics of a building design (such as the dimensions and construction materials of a wall) and obtain a heat loss or "U" value for the particular feature (such as the wall) . Such systems have considerable limitations, however. Firstly, they are very inflexible and require considerable expertise to use. Secondly, they enable only the employment of very simple construction data and a very basic calculation principles. They are not, therefore, appropriate for use with complex constructions or to use to take into consideration the effects of more complex thermal characteristics of a building, such as thermal bridges in structures for example. Furthermore, they provide little ability for a building designer to determine in a clear and concise manner the effect of particular materials on regulation compliance and do not provide flexibility in terms of transfer of input data to the calculation of other building characteristics, such as ventilation requirements, lighting requirements or life cycle assessment, for example. Furthermore, they provide no ability for the designer to then output information relating to the type or quantity of materials that might be needed in a particular construction or the cost of such materials. The present invention seeks to overcome some of the above problems.

According to the present invention there is provided a system for assisting in the determination of building specification compliance with a predetermined regulation, the system comprising:
construction data receiving means for receiving, from a user, construction data relating to a component in a building design, the construction data receiving means including reference data storage means from which a user can select reference construction materials and construction configurations to input as construction data for a component;
calculating means for calculating, on the basis of the input construction data, compliance data to be output to a user; and
display means for displaying the compliance data along side the component for which it has been calculated.

The calculating means may calculate the compliance data also on the basis of a compliance calculation. The system may comprise means for selecting differing compliance calculations and, if so, the system may have means for using the selected calculation to produce the compliance data.

The system may further comprise means for outputting a list of required material quantities and/or characteristics once a user has indicated that a calculation is complete.

The system may comprise means for receiving updated component or construction data and/or compliance calculations either through manual or automated input, which may be input by a user or from external source.

The system may further comprise means for transmitting data to and from a remote site, in which case the display may be at the remote site.

The regulations for which the system may be able to determine compliance may be one or more from the group of: thermal insulation, acoustic insulation, fire safety ventilation, life cycle, heating and air conditioning ventilation, lighting, safety, or moisture absorption.

The present invention, by enabling the simple selection or input of component information and appropriate flexibility in terms of the ability to select the compliance calculation provides a system which is simple and efficient to use.

By displaying compliance data alongside the component for which it has been calculated it is easy for a designer to see exactly what effect a particular component has had on the overall compliance of a building, making it possible for the designer to quickly and efficiently work out areas where compliance is weak or, indeed, overly strong.

Furthermore, the present invention also provides a system in which it is possible for a designer to input instruction data only once and then determine compliance with a variety of different regulations. By doing this, a considerable amount of overall analysis time is reduced in terms of reduced data input time, and the likelihood of errors through data entry is also reduced.

There are also benefits in a number of other features of the invention. In particular, there are many areas of building regulation in which there are now differing standards, for example both national and international standards. A designer may wish to ensure compliance only with a local standard, or may have a desire to ensure compliance with an international standard, and the ability to select the appropriate calculation therefore ensures that a designer's desires are met. In addition, a selection of differing calculations can ensure that a truly optimum design can be produced in which more than the single factor of meeting one regulation is taken into consideration.

Furthermore, ability for the system to be up-dated with construction and component data means that it is able to take into consideration any of the latest construction techniques and materials, as well as being able to consider their current cost in any calculation provisions. The ability to provide the data remotely enables the designer to be located anywhere, and even enables a designer to be at a building site whilst checking data and up-dating design requirements as required.

An example of the present invention will now be described with reference to the accompanying drawings, in which:
Figure 1 is a schematic block diagram showing the underlying operating components of a system according to the present invention; and
Figures 2 to 7 show example display outputs from the system of the invention.

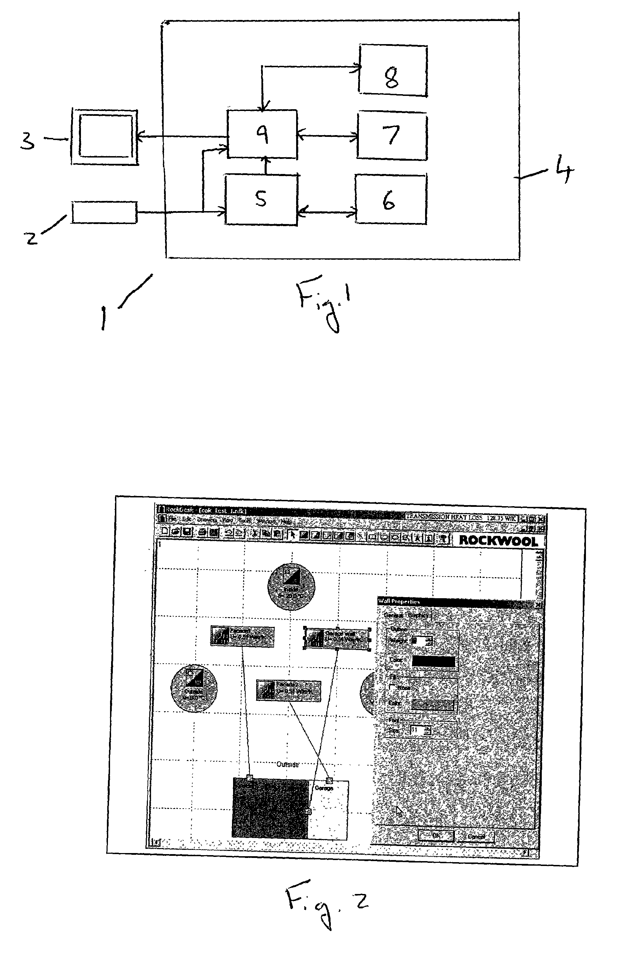

Referring to figure 1, a system 1 according to the invention is provided with a keyboard 2 for receipt of data input from a user, such as a building designer. A display 3 provides visual data output to the user in a manner that will be described below. Both the keyboard 2 and display 3 are connected to a processing system 4 that may be an appropriately configured personal computer, portable computer or network terminal. It will also be appreciated that certain components of the processing system 4 may be provided at one or more remote locations. The processing system 4 comprises a first memory 5 which provides means for storing data input from the user by the keyboard 2. A second memory 6 stores reference data relating to particular construction materials and construction configurations. A third memory 7 stores data related to the performance of calculations associated with a particular regulation for which compliance may be sought. There may be further memories 8 which store data related to additional compliance calculations which may either be differing calculations for the same regulation or for further regulations for which compliance confirmation is required. It will be appreciated that all of these memories may be provided by a single larger and appropriately configured memory (not shown).

A processor 9 receives data from the relevant memories in a manner that will be described below, performs an appropriate calculation and then outputs calculated compliance data to the display 3 in a manner that will also be described below.

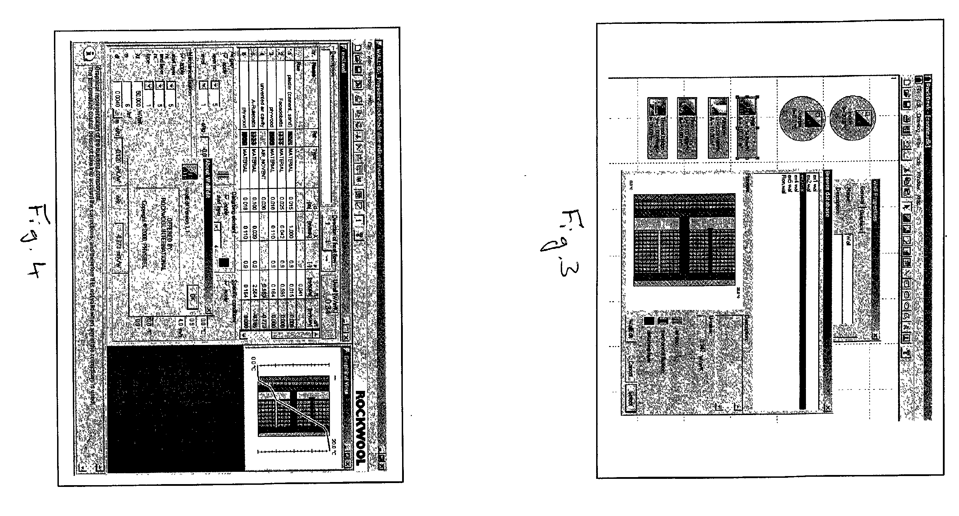

Referring now to figure 2, a system according to the invention produces a display in a Windows (RTM) style format which, whilst advantageous in that it provides the user with a well known format, it is not essential to the operation of the invention. As can be seen, the display of figure 2 shows a simple building construction with external walls and interior wall dividing a garage from the rest of the building. This structure can be input by a user, together with other information such as average outside and inside temperatures. The input may be via a menu bar or by the well known "point and click" approach. In the example shown in the figures, the overall result of operation of the system is to provide heat insulation characteristics for a building so that compliance with an individual national or international regulation can be determined. So, if other regulations, such as acoustic compliance, were required then other information, such as acceptable noise levels and likely interior noise levels may be input in place of temperature characteristics.

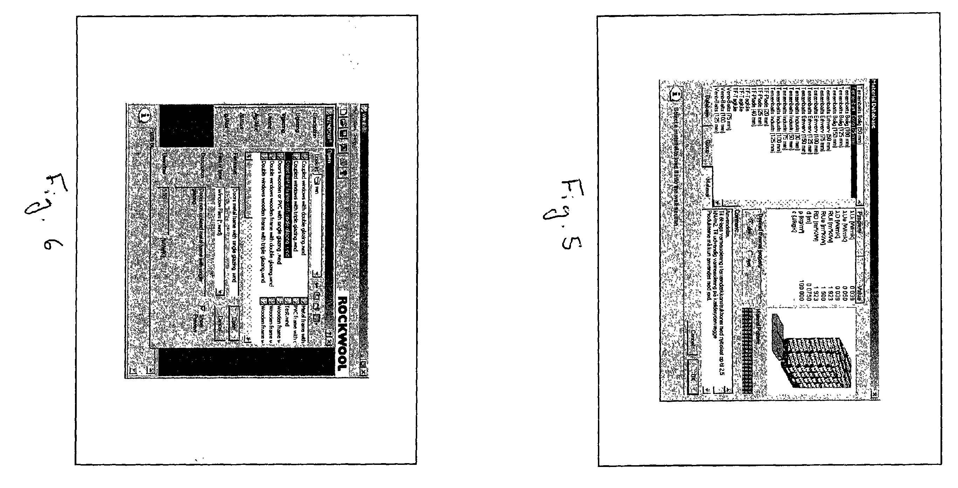

Within the input of the data relating to the construction of the building the system enables a user to select from a pre-defined database, of building construction types. This is shown in figure 3, where standard layered wall constructions are listed for a user to select.

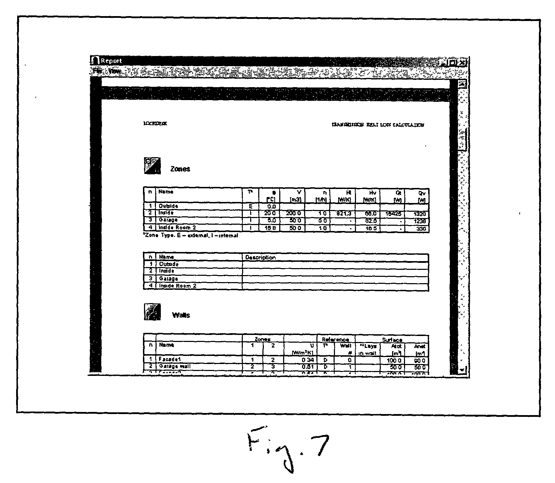

Alternatively, the user can input a bespoke construction, as shown for a wall in figure 4. In this figure it can be seen that material thickness and types can be inserted, as well as information in relation to other constructional features such as retaining bolts, nails, woodwork, etc.

In relation to this feature, the system 1 also provides a database of known products and stores with them associated physical parameter data. This is shown in figure 5, where a variety of insulating materials of different thickness and type are listed. These features, together with the standard construction type may be stored at a remote database (not shown) so that they can be updated immediately from the material providers and by other construction industry information providers. Alternatively, the system may be configured such that at regular intervals it contacts a remote source so that the data stored in memory 6 is updated and/or the system can provide for a user to input manually data on standard constructions and materials.

As can be seen from figure 6, the system 1 also provides information in relation to other building features, such as doors and windows that, again, can be standardised in a single standard component database that may be updated by appropriate material providers.

Once a user has selected all of the features of a building, including window and door locations and construction, ceiling and floor materials, roofing materials etc, the user is able to select at least one set of calculations relating to at least one regulation for which compliance is to be determined.

If we take the example of thermal insulation regulation, it is therefore possible for a building designer to consider a local national standard, or if for example they are a national of a European Union country to choose a European standard. The latter, often referred to is a complex standard that employs machine calculations using a program known as eg, "Eurocobra" (RTM) for calculating of thermal bridges and takes into consideration many factors in a wall, floor, ceiling, window and door construction and makes a highly complex calculations based thereon. A local standard is often less complex, but is weighted such that it may well conform with the European standard by overcompensating in many respects such that European standard is exceeded by a considerable degree. A designer may therefore wish to meet the European standard but accept that this will require additional complexity of calculation but perhaps reduced cost in terms of amounts of material and complexity of construction, alternatively a building designer may wish to have a less specific calculation but accept the potential for increased use in material and cost. The system of the invention provides this freedom of choice to the designer in a manner not available previously.

Once an appropriate calculation standard has been accepted the processor 9 of the system of the invention retrieves the appropriate calculation data and performs the calculation based upon the information provided by the user. This can then be output to the display 3 in a manner shown in figure 7, in which overall ratings are provided for zones in the building and/or for individual features in individual zones. Because of the simple tabular format of the data, which may actually also be produced in a graphical representation with the general appearance of the building being shown with associated data display therewith, a designer can readily appreciate the areas in which compliance is met and compliance is not met. This provides exceptionally quick feedback to a designer, who can then concentrate on the weakest areas to ensure overall compliance. Indeed, it also means that a designer can see the areas where compliance is exceeded to such a degree that a lower standard of materials and/or construction may be provided but the regulations still met, allowing excessive use of materials avoided.

Once an assessment has been made for one regulation the system 1 may provide for the ability for a user to select a different regulation, perhaps an acoustic or fire safety regulation, for example, and a calculation performed by accessing the appropriate calculation data, without the need for a user to re-input all the construction data. The system may also provide for the ability for a user to back-track to previously assessed regulations once an adjustment has been made to building design in relation to a regulation being exceeded to too higher a degree, or, indeed, not met.

## Claims

1. A system for assisting in the determination of building specification compliance with a predetermined regulation, the system comprising:
construction data receiving means for receiving, from a user, construction data relating to a component in a building design, the construction data receiving means including reference data storage means from which a user can select reference construction materials and construction configurations to input as construction data for a component;
means for calculating, on the basis of the input construction data, compliance data to be output to a user; and
display means for displaying the compliance data along side the component for which it has been calculated.

2. A system according to claim 1, wherein the calculating means calculates compliance data also on the basis of a compliance calculation, the system further comprising means for selecting differing compliance calculations.

3. A system according to claim 2, the system having means for using the selected calculation to produce the compliance data.

4. A system according to claim 2 or claim 3 wherein compliance with plural differing types of regulation can be performed for the input construction data.

5. A system according to any of claims 1 to 4, the system further comprising means for outputting a list of required material quantities and/or material characteristics once a user has indicated that a calculation is complete.

6. A system according to any preceding claim, the system further comprising means for receiving updated component or construction data and/or compliance calculations.

7. A system according to any preceding claim, the system further comprising means for transmitting data to and from a remote site.

8. A system according to any preceding claim, in which the regulation for which the system is able to determine compliance is one or more from the group of: insulation, acoustic, fire safety, ventilation, life cycle, heating or air conditioning ventilation, lighting, safety, or moisture absorption.
